# FASCICULE DE BREVET EUROPEEN

(11) **EP 3 671 361 B1**
(45) Date de publication et mention de la délivrance du brevet: **26.08.2026**
(21) Numéro de dépôt: 18213618.4
(22) Date de dépôt: 18.12.2018
(51) Int. Cl.: G04B 15/14, G04B 19/04, G04B 13/02

(54) **COMPOSANT HORLOGER RENFORCÉ**
VERSTÄRKTE UHRENKOMPONENTE
REINFORCED TIMEPIECE COMPONENT

(43) Date de publication de la demande: 24.06.2020
(73) Titulaire: ROLEX SA, 1211 Genève 26 (CH)
(72) Inventeur: FAVEZ, Denis, 1218 Le Grand-Saconnex (CH); HENIN, Stefano, 1162 Saint-Prex (CH)
(74) Mandataire: Moinas & Savoye SARL

(56) Documents cités:
- EP-A1- 2 277 822
- EP-A1- 3 339 968
- EP-A2- 1 904 101
- WO-A1-2015/113973
- CH-A2- 702 431
- CH-A2- 707 986
- FR-A5- 2 136 037
- US-A1- 2017 285 573

## Description

L'invention concerne un procédé de fabrication d'un composant horloger à partir d'un matériau micro-usinable, par exemple du silicium. Elle concerne aussi un composant horloger, et un mouvement horloger et une pièce d'horlogerie comprenant un tel composant horloger.

Le silicium est un matériau présentant de multiples avantages pour la fabrication de composants horlogers. Il permet d'une part la fabrication simultanée d'un grand nombre de pièces de petite taille, avec une précision micrométrique. D'autre part, il a une faible densité et un caractère diamagnétique. Ce matériau présente toutefois un inconvénient : il ne possède pas, ou peu, de domaine de déformation plastique, ce qui en fait un matériau au comportement fragile. Une sollicitation mécanique ou un choc peuvent ainsi conduire à une rupture du composant sans déformation préalable. La manipulation des composants horlogers en silicium, notamment lors de leur fabrication et de leur assemblage, s'avère donc particulièrement délicate.

La fragilité des composants horlogers en silicium est accentuée par leur découpage dans un substrat de silicium, généralement réalisé par une technique de gravure profonde, par exemple par gravure réactive ionique profonde DRIE (de l'anglais « *Deep Reactive Ion Etching* »). Une spécificité de ce type de gravure est de former des ouvertures ayant des flancs légèrement ridés qui présentent en surface des défauts sous la forme de vaguelettes (en anglais « *scalloping* ») ou sous la forme de piqûres. Il en résulte une certaine rugosité des flancs gravés qui affaiblit la résistance mécanique du composant. En outre, ces défauts présents en surface des flancs peuvent générer des amorces de fissure, notamment en cas de sollicitation mécanique, et mener à la casse du composant sous des contraintes inférieures à la résistance usuelle du matériau.

Pour améliorer les propriétés mécaniques des composants horlogers en silicium, plusieurs approches ont déjà été proposées.

Une première approche, décrite dans le document EP1904901, consiste à former une couche d'oxyde de silicium par oxydation thermique du silicium à une température comprise entre 900°C et 1200°C. La couche d'oxyde formée résulte d'une conversion du silicium en surface du composant en oxyde de silicium. Ce document précise que cette couche est d'au moins 5 nm et reste inférieure strictement à 1 micron en pratique.

Le document EP2277822 décrit une variante de cette première approche, dans laquelle la couche d'oxyde formée est ensuite dissoute. La formation de la couche d'oxyde de silicium puis sa dissolution permettent de retirer la couche en surface du silicium comportant une partie des défauts et/ou amorces de fissures et d'arrondir les rugosités. Cette solution consiste finalement à réaliser un lissage de la surface du silicium dit par oxydation - désoxydation.

Ces deux solutions, qui appliquent la première approche pour l'oxydation, présentent l'inconvénient de consommer du silicium et de modifier les dimensions initiales de l'ébauche en silicium du composant horloger.

Une deuxième approche décrite dans le document « Silicon Profile Transformation and Sidewall Roughness Reduction Using Hydrogen Annealing » de Lee & al. (IEEE, 2005), repose sur une solution de lissage de flancs de composants en silicium dans un domaine éloigné de l'horlogerie au moyen d'un traitement à l'hydrogène. La migration du silicium est favorisée par l'hydrogène et la température, et permet de lisser les défauts de surface des flancs sans consommer de silicium, donc sans affecter les dimensions initiales du composant. L'efficacité d'une telle approche est toutefois controversée et elle a surtout été développée dans le but de former des structures tridimensionnelles arrondies/sphériques dans le silicium.

Cette solution a été appliquée au domaine horloger dans le but d'arrondir les arêtes vives de pièces découpées dans divers matériaux, comme décrit dans le document CH702431.

La présente invention propose une solution améliorée de renforcement d'un composant horloger à partir d'un matériau micro-usinable, par exemple du silicium.

A cet effet, l'invention repose sur un procédé de fabrication d'un composant horloger, dans lequel on réalise une pièce formant une ébauche du composant horloger à partir d'un matériau micro-usinable, caractérisé en ce qu'il comprend une étape de lissage comprenant au moins un lissage à l'hydrogène d'au moins une partie de la surface de la pièce, et en ce qu'il comprend une étape de formation sur ladite au moins une partie de la surface de la pièce d'une couche d'oxyde d'épaisseur supérieure à 1 micromètre, voire supérieure ou égale à 2 micromètres, voire supérieure ou égale à 2,5 micromètres, voire supérieure ou égale à 3 micromètres, pour renforcer le composant horloger. Le composant horloger présente une résistance moyenne supérieure ou égale à 4000 MPa, et/ou présente une résistance minimale supérieure ou égale à 3000 MPa.

L'invention porte aussi sur un composant horloger en tant que tel obtenu par un tel procédé.

L'invention est précisément définie par les revendications.

L'invention sera mieux comprise à l'aide de la description suivante d'un mode de réalisation particulier d'un procédé de fabrication d'un composant horloger fait à titre non limitatif en relation avec les figures jointes parmi lesquelles :
La figure 1 représente la résistance obtenue sur différents lots de composants horlogers pour plusieurs épaisseurs de revêtement par une couche d'oxyde.
La figure 2 représente la résistance obtenue sur différents lots de composants horlogers, mettant en évidence les résultats positifs obtenus par la mise en œuvre d'un mode de réalisation de l'invention.
La figure 3 représente un dispositif de régulateur d'un mouvement horloger en vue de dessus, comprenant des composants horlogers selon un mode de réalisation de l'invention.
La figure 4 représente le dispositif de régulateur d'un mouvement horloger en coupe.
La figure 5 représente un mobile de bloqueur du dispositif de régulateur selon un mode de réalisation de l'invention.

Le concept de l'invention consiste à renforcer un composant horloger réalisé à partir d'un matériau micro-usinable à l'aide d'une couche d'oxyde épaisse, c'est-à-dire présentant notamment une épaisseur nettement supérieure aux épaisseurs choisies par les solutions de l'état de la technique, en combinaison avec un lissage du composant. Les solutions existantes de renforcement d'un composant en silicium à l'aide d'une couche d'oxyde appliquent en pratique une épaisseur d'oxyde strictement inférieure à 1 µm. L'obtention d'une telle épaisseur d'oxyde est chronophage, nécessitant typiquement une nuit de traitement, et entraîne une modification des dimensions du composant.

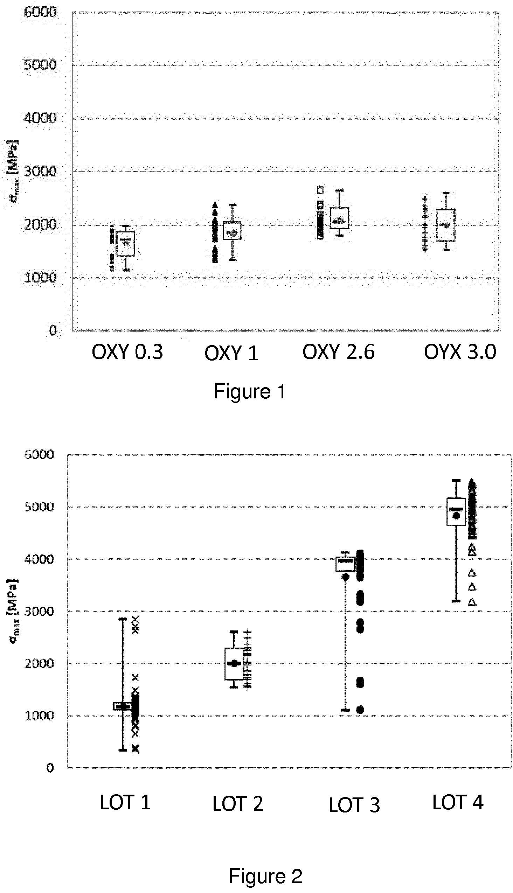

Des essais comparatifs consistant à faire varier l'épaisseur de la couche d'oxyde, notamment au-delà de la limite de 1 µm, ont été réalisés sur des éprouvettes de flexion trois points. En remarque, en raison du caractère fragile de la matière, les mêmes traitements de renforcement aboutissent à des résultats différents d'un composant horloger à un autre identique subissant a priori les mêmes contraintes. Pour cette raison, il est nécessaire de procéder à des tests sur des lots de composants identiques, puis d'en faire une analyse statistique pour constater ou non un effet. La figure 1 représente les résultats obtenus pour quatre lots avec une épaisseur d'oxyde respectivement égale à 0.3 µm, 1 µm, 2,6 µm, et 3 µm. La résistance à la rupture de chaque composant de chaque lot a été mesurée. Il apparaît que la résistance à la rupture moyenne augmente très légèrement avec l'augmentation de l'épaisseur jusqu'à atteindre l'épaisseur de 2,6 µm, puis se stabilise autour de 2000 MPa, sans amélioration pour l'épaisseur plus importante de 3 µm. La faible amélioration de la résistance à la rupture au regard de la forte augmentation de la durée de traitement nécessaire pour augmenter l'épaisseur de la couche d'oxyde rend cette approche finalement très peu intéressante. Autrement dit, l'effet des fortes épaisseurs n'est pas significativement efficace en regard du temps consacré à la réalisation de ces fortes épaisseurs et de la forte épaisseur de matériau impactée.

Pour ces raisons, il n'a jamais été imaginé de mettre en œuvre une épaisseur d'oxyde supérieure à 1 µm. Ce premier préjugé a été vaincu par l'invention, dont le choix d'épaisseurs significativement augmentées et combinées à une étape préalable de lissage, qui sera précisé par la suite, a permis d'aboutir à des renforcements inattendus des composants horlogers. Il n'a jamais été combiné un lissage avec la formation d'une couche d'oxyde dans le cadre du renforcement mécanique d'un composant, considérant ces deux solutions comme des alternatives équivalentes. Ce deuxième préjugé a de même été vaincu par l'invention, qui va démontrer une grande amélioration apportée par la combinaison d'un lissage avec une couche d'oxyde.

Le procédé de fabrication d'un composant horloger selon l'invention comprend une première phase de fabrication d'une ébauche d'un composant horloger, de manière connue. Par exemple, cette phase peut comprendre une étape initiale consistant à se munir d'un substrat en matériau micro-usinable. Ce substrat est par exemple une plaquette (ou « wafer » selon la terminologie anglo-saxonne) de silicium. Lors d'une étape suivante, on recouvre d'un revêtement protecteur la plaquette, notamment au moins une de ses deux faces dites supérieure et inférieure, par exemple par une résine photosensible. Le procédé se poursuit par une étape de formation d'un motif dans le revêtement protecteur. Le motif est réalisé en créant des ouvertures au travers de la couche de résine photosensible. Le revêtement protecteur ménageant des ouvertures constitue un masque de protection. Une étape de gravure de la plaquette de silicium à travers le masque de protection, notamment par gravure ionique réactive profonde DRIE (« *Deep Reactive Ion Etching »* selon la terminologie anglo-saxonne) permet ensuite de creuser des ouvertures dans le silicium au droit de la ou des ouverture(s) du masque, afin d'obtenir une ébauche de composant horloger en silicium.

L'invention s'intéresse à une deuxième phase de renforcement d'une telle ébauche de composant horloger, qui peut par ailleurs en variante être formé lors de la première phase par tout autre procédé que celui mentionné ci-dessus, par exemple par une technique de découpe laser.

Une première expérience consiste à mettre en œuvre une étape de lissage de l'ébauche de composant horloger, avant de former une couche d'oxyde épaisse. Une telle couche d'oxyde épaisse est formée sur tout ou partie de la surface de l'ébauche de composant horloger, de préférence sur toute sa surface, voire au moins 50%, voire 75%, de sa surface. Cette couche d'oxyde épaisse peut être réalisée par un procédé tel que décrit dans le document EP1904101, ou par tout autre procédé équivalent. L'étape de lissage de cette expérience comprend une étape d'oxydation et de désoxydation, par exemple telle que décrite dans le document EP2456714. Une phase d'oxydation - désoxydation peut par exemple comprendre une oxydation thermique à 1100°C durant 2h40, selon le procédé décrit dans le document EP1904101, suivie d'une dissolution à l'acide fluorhydrique de l'oxyde ainsi formé.

Sur la base de cette expérience, un mode de réalisation avantageux de l'invention ajoute une sous-étape de lissage à l'hydrogène à une étape préalable de lissage par oxydation désoxydation telle que mentionnée ci-dessus, avant de former la couche d'oxyde épaisse de manière similaire à celle décrite dans la première expérience ci-dessus. L'étape de lissage à l'hydrogène correspond à un traitement à l'hydrogène tel que décrit dans le document CH702431. Elle comprend un traitement de recuit de l'ébauche de composant horloger, ou au moins de sa surface traitée, dans une atmosphère réductrice sous des conditions de température et de pression adaptées pour provoquer la migration d'atomes de silicium à partir des arêtes vives, de manière à les arrondir. Selon un mode de réalisation, cette étape de lissage à l'hydrogène est réalisée à une température comprise entre 600°C et 1300°C et à une pression strictement supérieure à 100 Torr. En remarque, un lissage à l'hydrogène déplace les atomes de silicium, comme mentionné ci-dessus : en observant les arêtes, on constate que le lissage à l'hydrogène produit une sorte de renflement autour de l'arête, ce qui a pour effet indirect de les arrondir.

Finalement, il apparait que d'autres modes de réalisation peuvent être mis en œuvre, comprenant toute étape intermédiaire de lissage de surface comprenant au moins une étape de lissage à l'hydrogène avant de former une couche d'oxyde épaisse.

Dans tous ces modes de réalisation, la couche d'oxyde épaisse présente une épaisseur de préférence supérieure à 1 µm, voire supérieure ou égale à 1,5 µm ou à 2 µm ou à 2,5 µm ou à 3 µm ou à 3,2 µm. La couche d'oxyde est avantageusement inférieure ou égale à 5 µm. Cette couche d'oxyde présente avantageusement une épaisseur constante. En variante, elle peut présenter une épaisseur variable. Dans ce cas, les valeurs précédentes s'appliquent à l'épaisseur moyenne, ou à la valeur médiane d'épaisseur. De plus, dans les modes de réalisation décrits, la couche d'oxyde épaisse a été obtenue par un procédé tel que décrit dans le document EP1904101, mais elle peut en variante être obtenue par tout autre procédé.

Afin de démontrer l'avantage du procédé de fabrication d'un composant horloger renforcé selon les modes de réalisation de l'invention décrits précédemment, des essais comparatifs ont été réalisés sur des éprouvettes de flexion trois points. En remarque, en raison du caractère fragile de la matière, les mêmes traitements de renforcement aboutissent à des résultats différents d'un composant horloger à un autre identique subissant a priori les mêmes contraintes. Pour cette raison, il est nécessaire de procéder à des tests sur des lots de composants identiques, puis d'en faire une analyse statistique pour constater ou non un effet.

La figure 2 représente la résistance à la rupture de chaque pièce de chaque lot, ce qui permet de voir l'amplitude des résultats pour chaque lot. Pour chacun de ces lots, il est particulièrement intéressant d'observer la résistance à la rupture minimale, ainsi que la résistance à la rupture moyenne.

Un premier lot (lot 1) de pièces est un lot de référence, qui ne met pas en œuvre l'invention. Ce lot comprend des pièces en silicium découpées par la méthode DRIE avec un premier équipement, sans aucun post-traitement. La résistance à la rupture moyenne est faible et le risque de rupture prématurée d'un composant est élevé, en raison de la contrainte à la rupture minimale mesurée inférieure à 500 MPa.

Le deuxième lot (lot 2) est un lot qui comprend des pièces en silicium similaires au lot 1, réalisées avec une découpe par la méthode DRIE avec un deuxième équipement, mais comprenant un traitement de renforcement par la croissance d'une couche d'oxyde de trois microns d'épaisseur, sans lissage. Ce deuxième lot est une expérience intermédiaire pour aboutir à l'invention, qui met en œuvre l'intérêt d'une couche d'oxyde épaisse. Il apparaît que la résistance à la rupture moyenne de ce deuxième lot est plus élevée, de l'ordre de 2000 MPa, et que la contrainte à la rupture minimale se situe au-dessus de 1500 MPa.

Le troisième lot (lot 3) comprend des pièces en silicium similaires au lot 1, réalisées avec une découpe par la méthode DRIE avec un premier équipement, mais comprenant un traitement de renforcement par une étape intermédiaire de lissage par oxydation-désoxydation (croissance de 1 micron d'oxyde - dissolution HF) avant la croissance d'une couche d'oxyde de 2,87 microns d'épaisseur. Ce troisième lot correspond à la première expérience mentionnée précédemment, qui représente finalement une autre expérience intermédiaire avant d'aboutir à l'invention. La résistance à la rupture moyenne est encore augmentée (4000 MPa) par rapport au lot 2.

Le quatrième lot (lot 4) comprend des pièces en silicium similaires au lot 1, réalisées avec une découpe par la méthode DRIE avec un premier équipement, mais comprenant un traitement de renforcement par une étape intermédiaire de lissage par oxydation-désoxydation (croissance de 1 micron d'oxyde - dissolution HF) puis une étape de lissage à l'hydrogène, avant la croissance d'une couche d'oxyde de 2,87 microns d'épaisseur. Ce quatrième lot met en œuvre le mode de réalisation avantageux de l'invention décrit ci-dessus. Les performances sont ici clairement améliorées par rapport aux autres lots, tant au niveau de la contrainte à la rupture moyenne, qui avoisine les 5000 MPa, que pour la contrainte à la rupture minimale sur le lot, qui dépasse les 3000 MPa. Différents types de défauts sont éradiqués par la combinaison des lissages différents et la couche finale d'oxyde, très épaisse, contribue à colmater et lisser les derniers défauts présents.

La figure 2 illustre donc bien les effets avantageux surprenants obtenus par la mise en œuvre d'un procédé selon l'invention.

En variante non illustrée, il faut noter que des résultats satisfaisants peuvent être obtenus en mettant en œuvre uniquement une étape de lissage à l'hydrogène suivie de la croissance d'une couche d'oxyde épaisse.

En remarque, l'invention peut être combinée avec d'autres traitements connus, qui participent aussi à l'amélioration des performances d'un tel composant horloger. Ainsi, un traitement de renforcement mécanique de la pièce par un fluide d'attaque de type isotrope peut être mis en œuvre, par exemple par un procédé tel que décrit par le document EP2937311.

D'autre part, la couche d'oxyde selon l'invention peut éventuellement être recouverte par tout autre revêtement, de faible épaisseur, pour améliorer encore la résistance ou pour apporter une autre propriété au composant horloger, comme une tribologie différente. Ainsi, la couche d'oxyde épaisse de l'invention est une couche de surface en ce qu'elle se positionne à proximité de la surface du composant, mais n'est pas nécessairement la couche la plus externe du composant.

En remarque, dans les exemples décrits précédemment, le composant horloger comprend donc une base en silicium, recouverte d'une couche d'oxyde épaisse, qui est du dioxyde de silicium. En variante, on pourrait utiliser tout autre procédé de dépôt d'une couche d'oxyde, éventuellement différent de l'oxyde de silicium décrit ici. En variante encore, une couche de nitrure ou de carbure de silicium pourrait être déposée. En variante encore, une couche de carbure ou de nitrure de titane pourrait être déposée. Finalement, toute couche épaisse pourrait être utilisée, dès lors qu'elle permet de colmater les défauts de surface résiduels de la pièce. Selon une autre variante, plusieurs couches superposées, éventuellement de matériaux différents, parmi les couches susmentionnées, pourraient être utilisées.

Le procédé de l'invention permet donc la fabrication de composants horlogers réalisés à partir d'un matériau micro-usinable et ayant des propriétés mécaniques renforcées. Dans les exemples décrits précédemment, le matériau micro-usinable est le silicium. En variante, on pourrait utiliser un substrat en quartz, en diamant ou en tout autre matériau micro-usinable adapté à la fabrication d'un composant horloger. Dans ce cas, les traitements de lissage et de renforcement doivent être adaptés à chacune de ces matières.

D'autre part, le procédé de l'invention est adapté à la fabrication de tout composant horloger, notamment un composant horloger comportant des parties flexibles pour permettre son assemblage. A titre d'exemples illustratifs et non limitatifs, les composants horlogers peuvent être des roues dentées, des roues d'échappement, tout composant d'échappement, des aiguilles, des chevilles de plateau, des levées ainsi que des bascules ou d'autres ressorts horlogers, comme un ressort moteur d'horlogerie ou un ressort spiral d'oscillateur.

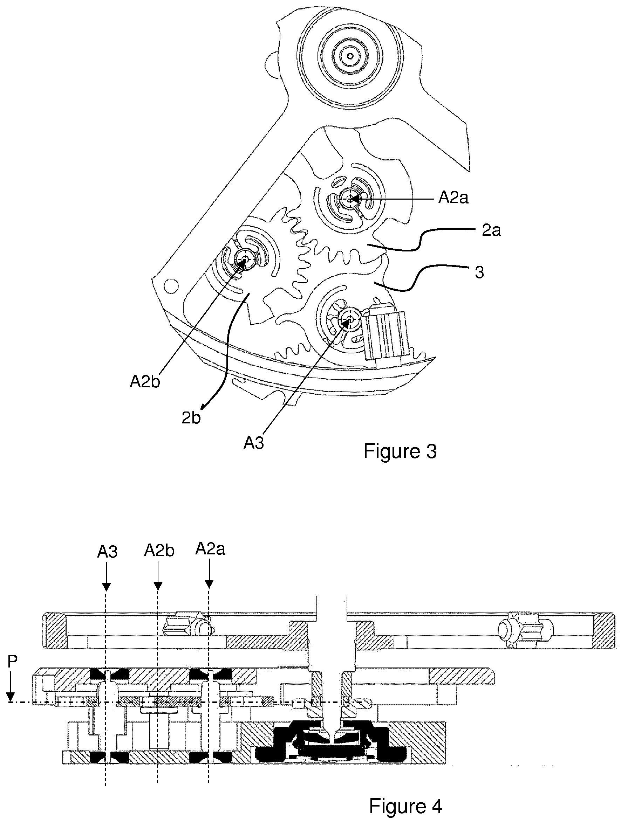

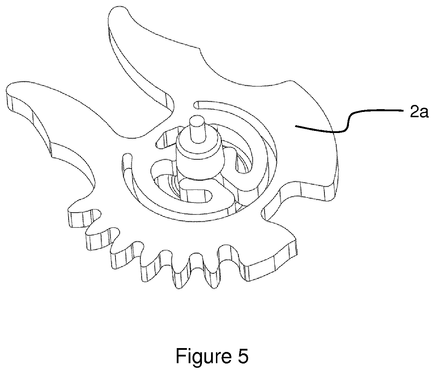

Par exemple, le procédé peut être adapté pour la réalisation des composants d'un dispositif de régulateur. Un tel dispositif de régulateur est illustré en figures 3 à 5. En particulier, il comprend notamment une roue d'échappement 3 pivotée autour d'un axe A3 et un bloqueur 2 comprenant un premier mobile de bloqueur 2a pivoté autour d'un troisième axe A2a et un deuxième mobile de bloqueur 2b pivoté autour d'un quatrième axe A2b, tous trois disposés dans le même plan P et réalisés en silicium.

De tels composants, de par leurs dimensions particulièrement petites et le caractère intrinsèquement fragile du matériau utilisé, s'avèrent délicats à assembler. Le risque de casse au moment du chassage de ces composants sur leur axe est élevé. Ainsi, de manière privilégiée, les composants 2a, 2b, et 3 comportent chacun une ouverture centrale délimitée par des bras élastiques dont des extrémités sont destinées à coopérer avec leur axe respectif. Le dimensionnement des bras élastiques est défini de sorte à fournir un couple de tenue adéquat des composants 2a, 2b, 3 sur chacun de leur axe respectif A2a, A2b, A3. Préférentiellement, le contour de l'ouverture centrale est non circulaire, à l'instar des ouvertures de viroles élastiques telle que décrites au sein du document WO2011/116486 ou du document WO2013/045706.

En raison des faibles dimensions des bras, il est nécessaire de maximiser la résistance mécanique du matériau et le procédé de l'invention permet de réduire le risque de casse lié à la contrainte à rupture minimale sur le lot.

L'invention concerne aussi un composant horloger fabriqué selon le procédé de fabrication qui vient d'être décrit, ainsi qu'une pièce d'horlogerie intégrant ce composant horloger.

Le composant horloger à base d'un matériau micro-usinable sera donc caractérisé en ce qu'au moins une partie de sa surface aura subi un lissage à l'hydrogène et comprend une couche d'oxyde d'épaisseur supérieure ou égale à 1, voire 2, voire 3 micromètres pour augmenter sa résistance mécanique, voire d'autres valeurs d'épaisseur listées précédemment.

Selon l'invention, le composant horloger est caractérisé en ce qu'il présente une résistance à la rupture moyenne supérieure ou égale à 4000 MPa, et/ou en ce qu'il présente une résistance à la rupture minimale supérieure ou égale à 3000 MPa.

Avantageusement encore, l'invention s'applique bien aux composants horlogers dit rigides, c'est-à-dire dont le fonctionnement ne fait pas appel ou très peu à une propriété d'élasticité, au contraire par exemple des ressorts, notamment en dehors d'un ressort moteur d'horlogerie ou d'un ressort de bascule. Ces composants rigides peuvent présenter des parties élastiques utiles à leur assemblage tel que décrit plus haut, mais non utilisée par la suite dans leur fonction horlogère. Autrement dit, de tels composants horlogers ne restituent aucune énergie qui proviendrait d'une déformation élastique lors de leur fonctionnement. Pour de tels composants, la résistance à la rupture est particulièrement importante et sollicitée, puisqu'ils ne peuvent par exemple pas amortir élastiquement d'éventuels efforts subis puisqu'ils ne sont pas conçus pour exploiter une élasticité.

## Revendications

1. Composant horloger à base d'un matériau micro-usinable comprenant au moins une partie de surface de matériau micro-usinable lissée au moins par un lissage à l'hydrogène et **caractérisé en ce qu'**il comprend une couche d'oxyde d'épaisseur supérieure à 1 micromètre pour augmenter sa résistance mécanique et **en ce que** le composant horloger présente une résistance moyenne supérieure ou égale à 4000 MPa, et/ou présente une résistance minimale supérieure ou égale à 3000 MPa.

2. Composant horloger selon la revendication précédente, **caractérisé en ce que** la couche d'oxyde présente une épaisseur supérieure ou égale à 2 micromètres, voire supérieure ou égale à 2,5 micromètres, voire supérieure ou égale à 3 micromètres.

3. Composant horloger selon l'une des revendications précédentes, **caractérisé en ce que** le matériau micro-usinable est du silicium et la couche d'oxyde de l'oxyde de silicium.

4. Composant horloger selon l'une des revendications précédentes, **caractérisé en ce qu'**il est un composant horloger en silicium d'un dispositif d'échappement.

5. Composant horloger selon l'une des revendications 1 à 4, **caractérisé en ce qu'**il est un composant horloger rigide sans restitution d'énergie par élasticité et/ou **en ce qu'**il est l'un des éléments du groupe comportant une roue dentée, une roue d'échappement, une aiguille, une cheville de plateau, une levée.

6. Mouvement horloger, **caractérisé en ce qu'**il comprend un composant horloger selon l'une des revendications précédentes.

7. Pièce d'horlogerie, **caractérisée en ce qu'**elle comprend un composant horloger selon l'une des revendications 1 à 5 ou un mouvement horloger selon la revendication précédente.

8. Procédé de fabrication d'un composant horloger, dans lequel on réalise une pièce formant une ébauche du composant horloger à partir d'un matériau micro-usinable, comprenant une étape de lissage comprenant au moins un lissage à l'hydrogène d'au moins une partie de la surface de la pièce, et **caractérisé en ce qu'**il comprend une étape de renforcement mécanique de la pièce par la formation sur ladite au moins une partie de la surface de la pièce d'une couche d'oxyde d'épaisseur supérieure à 1 micromètre, voire supérieure ou égale à 2 micromètres, voire supérieure ou égale à 2,5 micromètres, voire supérieure ou égale à 3 micromètres, de sorte que le composant horloger présente une résistance moyenne supérieure ou égale à 4000 MPa, et/ou présente une résistance minimale supérieure ou égale à 3000 MPa.

9. Procédé de fabrication d'un composant horloger selon la revendication précédente, **caractérisé en ce que** l'étape de réalisation de la pièce formant une ébauche comprend un micro-usinage de la pièce, notamment par gravure ionique réactive profonde ou DRIE (« Deep Reactive Ion Etching ») et/ou par une technique de découpe laser.

10. Procédé de fabrication d'un composant horloger l'une des revendications 8 ou 9, **caractérisé en ce que** l'étape de lissage de ladite au moins une partie de la surface de la pièce comprend au préalable d'une étape de lissage à l'hydrogène une étape de lissage supplémentaire par oxydation-désoxydation.

11. Procédé de fabrication d'un composant horloger selon l'une des revendications 8 à 10, **caractérisé en ce qu'**il comprend une étape de traitement de renforcement mécanique de la pièce par un fluide d'attaque de type isotrope.

## Patentansprüche

1. Uhrenkomponente auf der Basis eines mikrobearbeitbaren Materials, die mindestens einen Oberflächenabschnitt aus mikrobearbeitbarem Material umfasst, der zumindest durch eine Wasserstoffglättung geglättet wurde, **dadurch gekennzeichnet, dass** sie eine Oxidschicht mit einer Dicke von mehr als 1 Mikrometer umfasst, um ihre mechanische Festigkeit zu erhöhen, und dass die Uhrenkomponente eine mittlere Festigkeit von größer oder gleich 4000 MPa aufweist und/oder eine Mindestfestigkeit von größer oder gleich 3000 MPa aufweist.

2. Uhrenkomponente nach dem vorhergehenden Anspruch, **dadurch gekennzeichnet, dass** die Oxidschicht eine Dicke von größer oder gleich 2 Mikrometern, gegebenenfalls größer oder gleich 2,5 Mikrometern, gegebenenfalls größer oder gleich 3 Mikrometern aufweist.

3. Uhrenkomponente nach einem der vorhergehenden Ansprüche, **dadurch gekennzeichnet, dass** das mikrobearbeitbare Material Silizium und die Oxidschicht Siliziumoxid ist.

4. Uhrenkomponente nach einem der vorhergehenden Ansprüche, **dadurch gekennzeichnet, dass** sie eine Uhrenkomponente aus Silizium einer Hemmvorrichtung ist.

5. Uhrenkomponente nach einem der Ansprüche 1 bis 4, **dadurch gekennzeichnet, dass** sie eine starre Uhrenkomponente ohne Energierückgabe durch Elastizität ist und/oder dass sie eines der Elemente der Gruppe ist, die ein Zahnrad, ein Hemmrad, einen Zeiger, einen Hebelstift und eine Hebung umfasst.

6. Uhrwerk, **dadurch gekennzeichnet, dass** es eine Uhrenkomponente nach einem der vorhergehenden Ansprüche umfasst.

7. Uhr, **dadurch gekennzeichnet, dass** sie eine Uhrenkomponente nach einem der Ansprüche 1 bis 5 oder ein Uhrwerk nach dem vorhergehenden Anspruch umfasst.

8. Verfahren zur Herstellung einer Uhrenkomponente, bei dem ein ein Rohling der Uhrenkomponente bildendes Teil aus einem mikrobearbeitbaren Material hergestellt wird, umfassend einen Glättungsschritt mit mindestens einer Wasserstoffglättung mindestens eines Teils der Oberfläche des Teils, **dadurch gekennzeichnet, dass** es einen Schritt zur mechanischen Verstärkung des Teils durch Bildung einer Oxidschicht mit einer Dicke von mehr als 1 Mikrometer, gegebenenfalls größer oder gleich 2 Mikrometern, gegebenenfalls größer oder gleich 2,5 Mikrometern, gegebenenfalls größer oder gleich 3 Mikrometern auf dem genannten mindestens einen Teil der Oberfläche des Teils umfasst, sodass die Uhrenkomponente eine mittlere Festigkeit von größer oder gleich 4000 MPa aufweist und/oder eine Mindestfestigkeit von größer oder gleich 3000 MPa aufweist.

9. Verfahren zur Herstellung einer Uhrenkomponente nach dem vorhergehenden Anspruch, **dadurch gekennzeichnet, dass** der Schritt zur Herstellung des den Rohling bildenden Teils eine Mikrobearbeitung des Teils umfasst, insbesondere durch tiefes reaktives Ionenätzen oder DRIE (« Deep Reactive *Ion* Etching ») und/oder durch eine Laserschneidetechnik.

10. Verfahren zur Herstellung einer Uhrenkomponente nach einem der Ansprüche 8 und 9, **dadurch gekennzeichnet, dass** der Schritt zur Glättung des genannten mindestens einen Teils der Oberfläche des Teils vor einem Wasserstoffglättungsschritt einen zusätzlichen Glättungsschritt durch Oxidation-Desoxidation umfasst.

11. Verfahren zur Herstellung einer Uhrenkomponente nach einem der Ansprüche 8 bis 10, **dadurch gekennzeichnet, dass** es einen Schritt zur mechanischen Verstärkung des Teils mittels eines isotropen Ätzfluids umfasst.

## Claims

1. A timepiece component based on a micromachinable material, wherein it comprises at least one micromachinable-material surface portion that is smoothed at least by hydrogen smoothing, **characterized in that** it comprises an oxide layer of thickness larger than 1 micron in order to increase its mechanical strength, and **in that** the timepiece component has a mean strength higher than or equal to 4000 MPa, and/or has a minimum strength higher than or equal to 3000 MPa.

2. The timepiece component as claimed in the preceding claim, **characterized in that** the oxide layer has a thickness larger than or equal to 2 microns, or even larger than or equal to 2.5 microns, or even larger than or equal to 3 microns.

3. The timepiece component as claimed in one of the preceding claims, **characterized in that** the micromachinable material is silicon and the oxide layer silicon oxide.

4. The timepiece component as claimed in one of the preceding claims, **characterized in that** it is a timepiece component made of silicon of an escapement device.

5. The timepiece component as claimed in one of claims 1 to 4, **characterized in that** it is a rigid timepiece component that does not release energy by elasticity and/or **in that** it is one of the elements of the group comprising a toothed wheel, an escapement wheel, a hand, an impulse pin and a pallet.

6. A timepiece movement, **characterized in that** it comprises a timepiece component as claimed in one of the preceding claims.

7. A timepiece, **characterized in that** it comprises a timepiece component as claimed in one of claims 1 to 5 or a timepiece movement as claimed in the preceding claim.

8. A process for manufacturing a timepiece component, in which a part forming an unfinished timepiece component is produced from a micromachinable material, comprising a smoothing step comprising at least hydrogen smoothing of at least one portion of the surface of the part, **characterized in that** it comprises a step of mechanically strengthening the part by forming, on said at least one portion of the surface of the part, an oxide layer of thickness larger than 1 micron, or even larger than or equal to 2 microns, or even larger than or equal to 2.5 microns, or even larger than or equal to 3 microns, such that the timepiece component has a mean strength higher than or equal to 4000 MPa, and/or has a minimum strength higher than or equal to 3000 MPa.

9. The process for manufacturing a timepiece component as claimed in the preceding claim, **characterized in that** the step of producing the part forming an unfinished timepiece component comprises micro-machining the part, in particular by deep reactive-ion etching (DRIE) and/or using a laser cutting technique.

10. The process for manufacturing a timepiece component as claimed in either of claims 8 and 9, **characterized in that** the step of smoothing said at least one portion of the surface of the part comprises, prior to a step of hydrogen smoothing, a step of additional smoothing by oxidizing-deoxidizing.

11. The process for manufacturing a timepiece component as claimed in one of claims 8 to 10, **characterized in that** it comprises a processing step for mechanically strengthening the part using an isotropic fluid etchant.
